Europäisches Patentamt

European Patent Office

Office européen des brevets

(11) Publication number: **0 193 298**
**A2**

(12) **EUROPEAN PATENT APPLICATION**

(21) Application number: **86300789.4**

(22) Date of filing: **06.02.86**

(51) Int. Cl.⁴: **H 01 L 21/20**
**H 01 L 21/203, H 01 L 29/04**

(30) Priority: **23.02.85 GB 8504726**

(43) Date of publication of application:
**03.09.86 Bulletin 86/36**

(84) Designated Contracting States:
**AT BE CH DE FR IT LI LU NL SE**

(71) Applicant: **ITT INDUSTRIES INC.**
**320 Park Avenue**
**New York, NY 10022(US)**

(72) Inventor: **Scovell, Peter Denis**
**14 Staplecroft Spring Field**
**Chelmsford Essex(GB)**

(72) Inventor: **Baker, Roger Leslie**
**24 Rochford Cottages Stansted Mountfitchet**
**Essex(GB)**

(74) Representative: **Ruffhead, Philip Geoffrey**
**ITT-UK Patent Department Maidstone Road Foots Cray**
**Sidcup DA14 5HT(GB)**

(54) Method for the formation of epitaxial layers for integrated circuits.

(57) Epitaxial layers are formed on a silicon substrate by depositing a layer of α-silicon, e.g. by plasma enhanced chemical vapour deposition, at a temperature below 550°C. The layer is recrystallised to a single crystal layer by heating the structure to a temperature between 550 and 900°C. The technique overcomes the problems of wafer distortion experienced in conventional high temperature epitaxial growth.

EP 0 193 298 A2

Croydon Printing Company Ltd.

0193298

JTITLE MODIFIED
see front page

## IMPROVEMENTS IN INTEGRATED CIRCUITS

This invention relates to integrated circuits and in particular to the formation of epitaxial layers in the fabrication of such circuits.

In many integrated circuit fabrication processes it is necessary to provide a substrate silicon wafer with one or more epitaxial layers in which the circuit devices are subsequently formed. In conventional epitaxial processes silicon substrate wafers are exposed to an atmosphere containing silane or dichlorosilane at a temperature exceeding $1050^{\circ}C$. This high temperature process can cause temperature gradients across the wafer resulting in crystallographic slip, pattern distortion and wash out. Autodoping can also be a problem at the temperatures involved due to the high evaporation coefficients and is particularly severe for p-type epitaxial layers on $p^+$-type substrates.

The object of the present invention is to minimise or to overcome this disadvantage.

According to the invention there is provided a process for forming a single crystal surface layer on a single crystal silicon substrate, characterised by the steps of depositing a surface layer of $\alpha$-silicon on the substrate at a temperature below $550^{\circ}C$, and recrystallising the deposited layer at a temperature of $530^{\circ}$ to $900^{\circ}C$ to form a single crystal silicon layer.

Typically we deposit the $\alpha$-silicon surface

layer by a plasma enchanced chemical vapour deposition (PECVD) process. In this process the ⍺-silicon is deposited by thermal deposition from an atmosphere of silane, dichlorosilane or mixtures thereof under reduced pressure. To enhance the deposition process a radio-frequency plasma is maintained in the gas. To prevent the deposition of crystalline silicon the temprature should not exceed 600°C. Also, to provide a sufficiently high deposition rate, the temperature should not be less than 200°C. The film can be doped during deposition with phosphorus, arsenic, boron or mixtures thereof to provide the desired conductivity type and resistivity. Preferably this deposition stage is performed at 300 to 500°C. When deposition to the desired layer thickness has been completed the structure is then heated to a temperature between 550 and 900°C, preferably 600 to 800°C, to recrystallise the film to form a single crystal epitaxial layer.

The technique can be extended to selective epitaxy by the use of an oxide masking layer. Using this process epitaxial single crystal regrowth occurs only in the mask openings. Polysilicon is formed on the oxide surface and can be subsequently selectively removed to leave the oxide isolated epitaxial material.

In a further application the technique can be used to form deep junctions in silicon. This is of particular advantage when using large diameter substrates where the high temperatures required for conventional drive-in and anneal can cause wafer distortion. For this purpose a deep well is formed by etching an oxide masked silicon substrate to the desired depth. A layer of suitably doped ⍺-silicon

is then deposited on the substrate to completely fill the well and the structure is then recrystallised, preferably at a temperature below $800^{\circ}C$, to form a doped single crystal well. The material deposited on the mask is converted to polysilicon and is subsequently removed.

In a further application the doping of the $\alpha$-silicon can be varied during deposition to provide a graded epitaxial layer.

The technique is compatible with the low processing temperatures desirable for advanced VLSI processing on large substrates. Slip, pattern washout and distortion are virtually eliminated and the low deposition temperatures used eliminate the risk of autodoping.

0193298

-4-

CLAIMS:

1. A process for forming a single crystal surface layer on a single crystal silicon substrate, characterised by the steps of depositing a surface layer of $\alpha$-silicon on the substrate at a temperature below 550$^o$C, and recrystallising the deposited layer at a temperature of 530$^o$ to 900$^o$C to form a single crystal silicon layer.

2. A process as claimed in claim 1, characterised in that the $\alpha$-silicon is deposited by a plasma enhanced chemical vapour deposition process.

3. A process as claimed in claim 2, characterised in that the $\alpha$-silicon is deposited from silane, dichlorosilane or mixtures thereof.

4. A process as claimed in claim 1, 2 or 3, characterised in that the $\alpha$-silicon is crystallised at temperatures of 600 to 800$^o$C.

5. A process as claimed in any one of claims 1 to 4, characterised in that the $\alpha$-silicon is doped with phosphorus, arsenic, boron or mixtures thereof.

6. A process as claimed in any one of claims 1 to 5, characterised in that the substrate surface is partially masked by a patterned oxide coating.

7. A process as claimed in claim 5, characterised in that the $\alpha$-silicon is deposited in a well in the substrate surface.

8. A process as claimed in claim 5 or 7, characterised in that the doping of the $\alpha$-silicon is varied during deposition to provide a graded epitaxial layer.

9. A silicon wafer incorporating an epitaxial layer characterised in that the layer is formed by a process as claimed in any one of claims 1 to 8.

　　　10. An integrated circuit characterised in that it is fabricated in a wafer as claimed in claim 9.